# EUROPEAN PATENT SPECIFICATION

(11) **EP 1 467 487 B1**
(45) Date of publication and mention of the grant of the patent: **05.07.2006**
(21) Application number: 04006249.9
(22) Date of filing: 16.03.2004
(51) Int. Cl.: H03J 5/24, H03J 3/18

(54) **Tuned filter**
Abgestimmtes Filter
Filtre accordé

(30) Priority: 09.04.2003 JP 2003001955 U
(43) Date of publication of application: 13.10.2004
(73) Proprietor: ALPS ELECTRIC CO., LTD., Tokyo 145-8501 (JP)
(72) Inventor: Yamamoto, Masaki, c/o Alps Electric co., Ltd., Tokyo 145-8501 (JP)
(74) Representative: Klunker . Schmitt-Nilson . Hirsch

(56) References cited:
- EP-A- 1 047 192
- GB-A- 2 312 345
- US-A1- 2003 076 449

## Description

### BACKGROUND OF THE INVENTION

### 1. Field of the Invention

The present invention relates to an input tuning circuit switched so as to be tuned to two high and low frequency bands, for attenuating an image frequency with respect to a tuning frequency, and in particular, to an input tuning circuit suitable for a television tuner.

### 2. Description of the Related Art

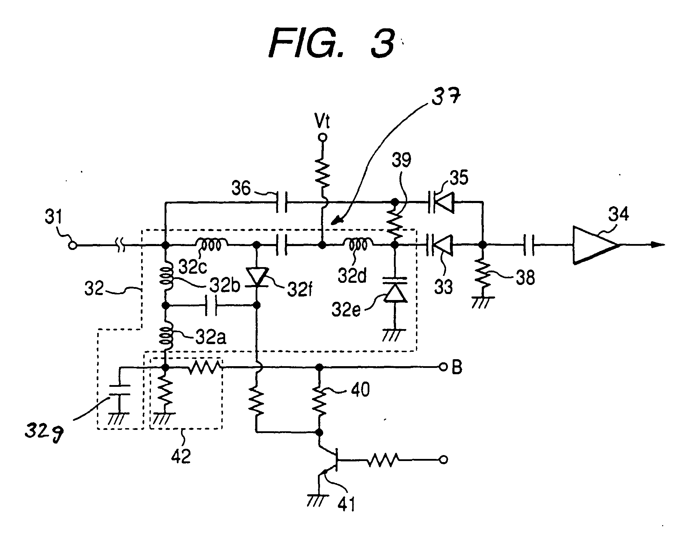

A conventional input tuning circuit will be described with reference to Fig. 3. A band switching tuning circuit 32 connected to an input terminal 31 comprises four serially connected inductance elements 32a through 32d, a first varactor diode 32e connected in parallel to all the inductance elements, and a switch diode 32f extended over two intermediate inductance elements 32b and 32c.

An end (at the side of the inductance element 32a) of the four serially connected inductance elements 32a through 32d is high-frequency grounded by a DC cut capacitance element 32g. The other end (at the side of the inductance element 32d) thereof is connected to the cathode of the first varactor diode 32e. The anode of the first varactor diode is grounded. The connection point of the two inductance elements 32b and 32c becomes the input end of the band switiching tuning circuit 32 and is connected to the input terminal 31. Also, the connection point of the inductance element 32d and the first varactor diode 32e becomes the output end of the band switching tuning circuit 32 and is connected to a high frequency amplifier 34 of the next stage through a coupling second varactor diode 33.

Therefore, the two inductance elements 32c and 32d and the two varactor diode 33 are serially connected between the input end of the band switching tuning circuit 32 and the high frequency amplifier 34. In addition, a series circuit of a third varactor diode 35 and a capacitance element 36 is connected in parallel to all the two inductance elements 32c and 32d and the second varactor diode 33 to form a parallel resonance circuit 37. The anode of the third varactor diode 35 is connected to a ground together with the anode of the second varactor diode 33 through a resistor 38. The cathode of the third varactor diode is connected to the cathode of the second varactor diode 33 through a resistor 39. A tuning voltage Vt is applied to the cathodes of the first through third varactor diodes 32e, 33, and 35. Therefore, the voltage values applied between the anodes of the three varactor diodes 32e, 33, and 35 and the cathodes of the three varactor diodes 32e, 33, and 35 become equal to each other.

The cathode of a switch diode 32f is connected to the collector of a switch transistor 41 whose collector is pulled up to a power supply voltage B through a resistor 40. The emitter of the switch transistor is grounded. A voltage dividing circuit 42 for dividing the power supply voltage through a resistor is provided. The divided voltage is applied to the anode of the switch diode 32f through the inductance element 32a.

In the above-mentioned structure, for example, a television signal having a VHF band is input to the input terminal 31. When the switch transistor 41 is switched off, the switch diode 32f is also switched off. The band switching tuning circuit 32 is tuned to a low frequency band (a low band) of a VHF band by the four inductance elements 32a through 32d and the first varactor diode 32e. On the other hand, a parallel resonance circuit 37 resonates in a frequency higher than the tuning frequency of the band switching tuning circuit 32. The resonance frequency is changed, together with the tuning frequency, by a tuning voltage. The resonance frequency at this time is set so as to be an image frequency with respect to a television signal of a low band.

On the other hand, when the switch transistor 41 is switched on, the switch diode 32f is also switched on. The two inductance elements 32b and 32c are connected in parallel to each other. The band switching tuning circuit 32 is composed of the two other inductance elements 32a and 32d and the first varactor diode 32e, and is tuned to a high frequency band (a high band) of a VHF band. At this time, the resonance frequency of the parallel resonance circuit 37 rises since the inductance elements 32b and 32c are connected in parallel to each other. In addition, the resonance frequency is set so as to be an image frequency with respect to a television signal of a high band.

Therefore, the parallel resonance circuit 37 operates as the trap circuit for attenuating the image frequency in the low band and the high band.

The resonance frequency of the parallel resonance circuit 37 preferably changes from the tuning frequency of the band switching tuning circuit 32 with the same frequency difference. However, when the resonance frequency is set so as to change from the tuning frequency of the high band with a uniform frequency difference (by the capacitance element 36 serially connected to the third varactor diode 35) in the high band, since the frequency is low in the low band, the variable range of the resonance frequency is reduced and image interference is severe in the low frequency of the low band. The document GB-A-2 312 345 shows a similar input tuning circuit.

### SUMMARY OF THE INVENTION

It is an object of the present invention to improve image interference rejection by increasing the frequency variable range of a trap circuit, which is reduced in a low band.

To achieve the above object, the present invention provides an input tuning circuit, comprising a band switching tuning circuit having a first varactor diode and a plurality of inductance elements and switched so as to be tuned to a high frequency band or a low frequency band; a second varactor diode serially connected to the inductance elements for connecting the band switching tuning circuit to a high frequency amplifier of the next stage; and a third varactor diode connected in parallel to a series circuit of the inductance elements and the second varactor diode to form a parallel trap circuit for resonating an image frequency, wherein a common tuning voltage is applied to the cathodes of the first through third varactor diodes, and wherein the bias voltage of the anode of at least the third varactor diode is made higher in a case where the band switching tuning circuit is switched into the low frequency band, than a case where the band switching tuning circuit is switched into the high frequency band.

In addition, according to the input tuning circuit of the present invention, the band switching tuning circuit is provided with a switch diode having an anode to which a bias voltage is applied from a resistance voltage dividing circuit is applied, the switch diode being switched on when the band switching tuning circuit is tuned to the high frequency band and switched off when the band switching tuning circuit is tuned to the low frequency band, and the anode of the third varactor diode is direct-current connected to the anode of the switch diode.

Further, according to an input tuning circuit of the present invention, the anode of the second varactor diode is connected to the third varactor diode.

### BRIEF DESCRIPTION OF THE DRAWINGS

Fig. 1 is a circuit diagram illustrating the structure of an input tuning circuit according to the present invention;
Fig. 2 is a view illustrating the relationship between the voltage and the capacitance value of a varactor diode in the input tuning circuit according to the present invention; and
Fig. 3 is a circuit diagram illustrating the structure of a conventional input tuning circuit.

### [Reference Numerals]

1: INPUT TERMINAL
2: BAND SWITCHING TUNING CIRCUIT
2a to 2d: INDUCTANCE ELEMENT
2e: FIRST VARACTOR DIODE
2f: SWITCH DIODE
3: SECOND VARACTOR DIODE
4: HIGH FREQUENCY AMPLIFIER
5: THIRD VARACTOR DIODE
6: CAPACITANCE ELEMENT
7: PARALLEL RESONANCE CIRCUIT (TRAP CIRCUIT)
8, 9: RESISTOR
10: POWER SUPPLY RESISTOR
11: SWITCH TRANSISTOR
12: VOLTAGE DIVIDING CIRCUIT

### DESCRIPTION OF THE PREFERRED EMBODIMENTS

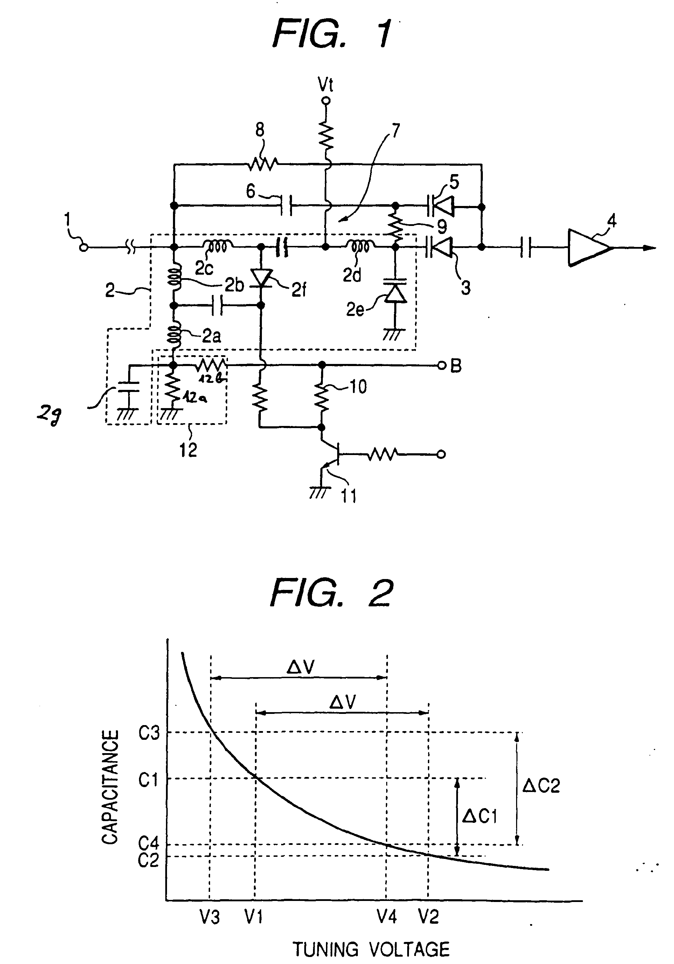

An input tuning circuit according to the present invention will now be described with reference to Fig. 1. A band switching tuning circuit 2 connected to an input terminal 1 includes four serially connected inductance elements 2a through 2d, a first varactor diode 2e connected in parallel to all the four inductance elements, and a switch diode 2f extended over all the two intermediate inductance elements 2b and 2c.

An end (at the side of the inductance element 2a) of the four serially connected inductance elements 2a through 2d is high-frequency grounded by a DC cut capacitance element 2g. The other end (at the side of the inductance element 2d) thereof is connected to the cathode of the first varactor diode 2e. The anode of the first varactor diode is grounded. The connection point of the two inductance elements 2b and 2c becomes the input end of the band switching tuning circuit 2, and is connected to the input terminal 1. The connection point of the inductance element 2d and the first varactor diode 2e becomes the output end of the band switching tuning circuit 2 and is connected to a high frequency amplifier 4 of the next stage through a coupling second varactor diode 3.

Therefore, the two inductance elements 2c and 2d and the second varactor diode 3 are serially connected between the input end of the band switching tuning circuit 2 and the high frequency amplifier 4. A series circuit of a third varactor diode 5 and a capacitance element 6 is connected in parallel to all the two inductance elements 2c and 2d and the second varactor diode 3. Therefore, a parallel resonance circuit 7 is formed between the input end of the band switching tuning circuit 2 and the anode of the second varactor diode 3. The anode of the third varactor diode 5 is direct current-connected to the anode of a switch diode 2f together with the anode of the second varactor diode 3 through a resistor 8. The cathode of the third varactor diode is connected to the cathode of the second varactor diode 3 through a resistor. A tuning voltage Vt is applied to the cathodes of the first through third varactor diodes 2e, 3, and 5.

The cathode of the switch diode 2f is connected to the collector of a switch transistor 11 whose collector is pulled up to a power supply voltage B through a resistor 10. The emitter of the switch transistor is grounded. A voltage dividing circuit 12 for dividing the power supply voltage B through a resistor is provided. The divided voltage is applied to the anode of the switch diode 2f through the inductance element 2a. Therefore, the voltages of the cathodes of the second and third varactor diodes 3 and 5 are higher than the voltage of the anode of the first varactor diode 2e. As a result, the voltages of the cathodes of the second and third varactor diodes 3 and 5 are higher than the voltage between the anode of the first varactor diode 2e and the cathode of the first varactor diode and the voltage between the anodes of the second and third varactor diodes 3 and 5 and the cathodes of the second and third varactor diodes.

In the above-mentioned structure, for example, a television signal of a VHF band is input to the input terminal 1. When the switch transistor 11 is switched off, the switch diode 2f is also switched off. The band switching tuning circuit 2 is tuned to a low frequency band (a low band) of a low VHF band through the four inductance elements 2a through 2d and the first varactor diode 2e. A tuning frequency changes by changing a tuning voltage. At this time, the resonance frequency of the parallel resonance circuit 7 simultaneously changes. However, the resonance frequency is set so as to be higher than the tuning frequency, for example, so as to be an image frequency with respect to a television signal of a low band.

On the other hand, when the switch transistor 11 is switched on, the switch diode 2f is also switched on. The two inductance elements 2b and 2c are connected in parallel to each other. The band switching tuning circuit 2 comprises the two other inductance elements 2a and 2d and the first varactor diode 2e, and is tuned to a high frequency band (a high band) of a VHF band. At this time, the resonance frequency of the parallel resonance circuit 7 rises since the inductance elements 2b and 2c are connected in parallel to each other. Also, the resonance frequency is set as to be an image frequency with respect to a television signal of a high band.

Therefore, the parallel resonance circuit 7 operates as the trap circuit for attenuating the image frequency in the low band and the high band.

The voltage of the anodes of the second and third varactor diodes 3 and 5 is switched so as to rise when the switch transistor 11 is switched off (is tuned to the television signal of the low band) and to fall when the switch transistor 11 is switched on. Therefore, even if a tuning voltage of the same change range ΔV is applied to the cathodes of the first to third varactor diodes 2e, 3, and 5, the voltages of the cathodes of the second and third varactor diodes 3 and 5 with respect to the anodes of the second and third varactor diodes 3 and 5 are lower in a case where the switch transistor is tuned to the television signal of the low band, than in a case where the switch transistor is tuned to the television signal of the high band.

In other words, as illustrated in Fig. 2, when the switch transistor is tuned to the television signal of the high band, the tuning voltage in the range ΔV from V1 to V2 is applied. On the other hand, when the transistor is tuned to the television signal of the low band, the same range ΔV of the applied tuning voltage falls to the range from V3 to V4.

Since the capacitance value with respect to the voltage of the varactor diode rapidly increases as the applied voltage is decreased, as illustrated in Fig. 2, the capacitance change width ΔC2 (= C3 - C4) in the low band is larger than the capacitance change width ΔC1 (= C1 - C2) in the high band. Therefore, the variable range of the resonance frequency of the parallel resonance circuit 7 is larger than the conventional one in a case where the switch transistor 11 is tuned to the low band to improve image interference. Also, the anode of the second varactor diode 3 may be directly grounded. However, when the anode of the second varactor diode is separated from the ground and connected to the anode of the third varactor diode 5, the change range of the parallel resonance frequency significantly increases to thus reduce the amount of current when the switch diode 2f is switched on.

As mentioned above, according to the present invention, the common tuning voltage is applied to the cathodes of the first through third varactor diodes. The bias voltage of the anode of at least the third varactor diode is made higher in a case where the band switching tuning circuit is switched into a low frequency band, than in a case where the band switching tuning circuit is switched into a high frequency band, and thus, the capacitance change width in the low band increases corresponding to the tuning voltage. Therefore, the variable range of the resonance frequency of the parallel trap circuit in the low band is larger than it is in the conventional art, to improve image interference.

In addition, according to the input tuning circuit of the present invention, the band switching tuning circuit is provided with a switch diode having an anode to which a bias voltage is applied from a resistance voltage dividing circuit is applied, the switch diode being switched on when the band switching tuning circuit is tuned to the high frequency band and switched off when the band switching tuning circuit is tuned to the low frequency band, and the anode of the third varactor diode is direct-current connected to the anode of the switch diode. Therefore, the voltage of the anode of the third varactor diode in the low band becomes high to increase the change width of the capacitance value.

Also, since the anode of the second varactor diode is connected to the third varactor diode, it is possible to reduce the amount of current when the switch diode 2f is switched on.

## Claims

1. An input tuning circuit, comprising:
a band switching tuning circuit having a first varactor diode (2e) and a plurality of inductance elements which are switched by switching means so as to be tuned to a high frequency band or a low frequency band;
a second varactor diode (3) serially connected to the inductance elements for connecting the band switching tuning circuit to a high frequency amplifier (4) of the next stage; and
a third varactor diode (5) connected in parallel to a series circuit of the inductance elements and the second varactor diode to form a parallel trap circuit (7) for resonating at an image frequency,
wherein a common tuning voltage (Vₜ) is applied to the cathodes of the first through third varactor diodes, and
wherein the bias voltage of the anode of at least the third varactor diode is controlled by the switching means such that it is made higher in a case where the band switching tuning circuit is switched into the low frequency band, than a case where the band switching tuning circuit is switched into the high frequency band.

2. The input tuning circuit according to Claim 1,
wherein the band switching tuning circuit is provided with a switch diode having an anode to which a bias voltage is applied from a resistance voltage dividing circuit, the switch diode being switched on when the band switching tuning circuit is tuned to the high frequency band and switched off when the band switching tuning circuit is tuned to the low frequency band, and
wherein the anode of the third varactor diode is direct-current connected to the anode of the switch diode.

3. The input tuning circuit according to Claim 1 or 2, wherein the anode of the second varactor diode is connected to the third varactor diode.

## Patentansprüche

1. Eingangsabstimmschaltung, aufweisend:
eine Bandschaltabstimmschaltung mit einer ersten Varaktordiode (2e) und einer Mehrzahl von Induktivitätselementen, die von einer Schalteinrichtung so geschaltet werden, dass sie auf ein Hochfrequenzband oder ein Niedrigfrequenzband abgestimmt werden;
eine zweite Varaktordiode (3), die mit den Induktivitätselementen für das Verbinden der Bandschaltabstimmschaltung mit einem Hochfrequenzverstärker (4) der nächsten Stufe in Reihe geschaltet ist; und
eine dritte Varaktordiode (5), die mit einer Reihenschaltung der Induktivitätselemente und der zweiten Varaktordiode parallel geschaltet ist, um eine parallele Sperrschaltung (7) für das Schwingen auf einer Bildfrequenz zu bilden,
wobei eine gemeinsame Abstimmspannung (Vt) an die Kathoden der ersten bis einschließlich dritten Varaktordiode angelegt wird, und
wobei die Vorspannungsspannung der Anode wenigstens der dritten Varaktordiode von der Schalteinrichtung derart gesteuert wird, dass sie in einem Fall, in dem die Bandschaltabstimmschaltung auf das Niedrigfrequenzband geschaltet ist, höher gemacht wird als in einem Fall, in dem die Bandschaltabstimmschaltung auf das Hochfrequenzband geschaltet ist.

2. Eingangsabstimmschaltung nach Anspruch 1,
wobei die Bandschaltabstimmschaltung mit einer Schaltdiode mit einer Anode versehen ist, an die von einer Widerstandsspannungsteilungsschaltung eine Vorspannungsspannung angelegt wird, wobei die Schaltdiode eingeschaltet ist, wenn die Bandschaltabstimmschaltung auf das Hochfrequenzband abgestimmt ist und ausgeschaltet ist, wenn die Bandschaltabstimmschaltung auf das Niedrigfrequenzband abgestimmt ist, und
wobei die Anode der dritten Varaktordiode mit der Anode der Schaltdiode Gleichstrom-verbunden ist.

3. Eingangsabstimmschaltung nach Anspruch 1 oder 2, wobei die Anode der zweiten Varaktordiode mit der dritten Varaktordiode verbunden ist.

## Revendications

1. Circuit de syntonisation d'entrée, comprenant :
un circuit de syntonisation de commutation de bandes de fréquences, ayant une première diode à capacité variable (2e) et une pluralité d'éléments d'inductance, qui sont commutés par un moyen de commutation, de façon à être syntonisée sur une bande de fréquences haute ou une bande de fréquences basse ;
une deuxième diode à capacité variable (3), reliée en série aux éléments d'inductance, pour relier le circuit de syntonisation de commutation de bandes de fréquences à un amplificateur de haute fréquence (4) du niveau suivant et
une troisième diode à capacité variable (5), reliée en parallèle à un circuit série des éléments d'inductance et à la deuxième diode à capacité variable, pour former un circuit réjecteur parallèle (7), pour résonner à une fréquence image,
dans lequel une tension de syntonisation (Vt) commune est appliquée aux cathodes des première, deuxième et troisième diodes à capacité variable et
dans lequel la tension de polarisation de l'anode d'au moins la troisième diode à capacité variable est commandée par le moyen de commutation, de sorte qu'elle soit supérieure, dans un cas où le circuit de syntonisation de commutation de bandes de fréquences est commuté dans la bande de fréquences basse, par rapport à un cas où le circuit de syntonisation de commutation de bandes de fréquences est commuté dans la bande de fréquences haute.

2. Circuit de syntonisation d'entrée selon la revendication 1,
dans lequel le circuit de syntonisation de commutation de bandes de fréquences est pourvu d'une diode de commutation, ayant une anode à laquelle est appliquée une tension de polarisation, à partir d'un circuit de division de tension de la résistance, la diode de commutation étant mise en circuit quand le circuit de syntonisation de commutation de bandes de fréquences est syntonisé sur la bande de fréquences haute et mise hors circuit quand le circuit de syntonisation de commutation de bandes de fréquences est syntonisé sur la bande de fréquences basse et
dans lequel l'anode de la troisième diode à capacité variable est reliée en courant continu à l'anode de la diode de commutation.

3. Circuit de syntonisation d'entrée selon la revendication 1 ou 2,
dans lequel l'anode de la deuxième diode à capacité variable est reliée à la troisième diode à capacité variable.
